# EUROPÄISCHE PATENTSCHRIFT

(11) **EP 2 388 908 B1**
(45) Veröffentlichungstag und Bekanntmachung des Hinweises auf die Patenterteilung: **19.08.2015**
(21) Anmeldenummer: 11162921.8
(22) Anmeldetag: 19.04.2011
(51) Int. Cl.: H03B 5/12

(54) **Integrierter CMOS-Weitband-Taktgeber mit differentiellem Aufbau**
Integrated CMOS broadband clock with differential design
Horloge à large bande CMOS intégrée dotée d'un montage différentiel

(30) Priorität: 19.05.2010 DE 102010029140
(43) Veröffentlichungstag der Anmeldung: 23.11.2011
(73) Patentinhaber: Maxim Integrated GmbH, 8403 Lebring (AT)
(72) Erfinder: Akbari-Dilmaghani, Rahim Dr., 8010 Graz (AT)
(74) Vertreter: Bergmeier, Werner

(56) Entgegenhaltungen:
- EP-A2- 1 333 574
- WO-A2-2009/063374
- BERNY A D ET AL: "A wideband low-phase-noise CMOS VCO", PROCEEDINGS OF THE IEEE 2003 CUSTOM INTEGRATED CIRCUITS CONFERENCE. (CICC 2003). SAN JOSE, CA, SEPT. 21 - 24, 2003; [IEEE CUSTOM INTEGRATED CIRCUITS CONFERENCE.CICC], NEW YORK, NY : IEEE, US, Bd. CONF. 25, 21. September 2003 (2003-09-21), Seiten 555-558, XP010671087, DOI: 10.1109/CICC.2003.1249459 ISBN: 978-0-7803-7842-1

## Beschreibung

Die vorliegende Erfindung bezieht sich auf das technische Gebiet der Elektrotechnik, insbesondere auf Halbleiter-Schaltkreise der Mikroelektronik. Vorgestellt wird eine integrierte Schaltung oder ein Schaltungsteil zur Erzeugung von Taktpulsen, welche insbesondere in Systemen für die drahtlose Kommunikation digitalisierter Daten Verwendung finden.

Insbesondere betrifft die vorliegende Erfindung einen CMOS-integrierten, differentiell aufgebauten Weitband-Taktgeber
mit einem spannungsgesteuertem Oszillator zum Erzeugen eines differentiellen Oszillatorsignals, umfassend zwei kreuzgekoppelte PMOS-Transistoren, welche jeweils einen Source-Anschluss, einen Drain-Anschluss und einen Gate-Anschluss aufweisen, weiter umfassend eine symmetrische Kapazitätsdiodenschaltung, welche eine durch eine Steuerspannung einstellbare Kapazität aufweist, welche zwischen den beiden Drain-Anschlüssen der kreuzgekoppelten PMOS-Transistoren wirkt, weiter umfassend eine zur Kapazitätsdiodenschaltung parallel geschaltete Induktivitätsschaltung, welche einen Mittenabgriff aufweist, und weiter umfassend zwei Ausgangsanschlüsse zum Abgreifen des differentiellen Oszillatorsignals, welche jeweils mit einem der Drain-Anschlüsse der kreuzgekoppelten PMOS-Transistoren verbunden sind
mit wenigstens einem positiven Versorgungskontakt zum Führen eines positiven Potentials einer Spannungsversorgung,
mit wenigstens einem negativen Versorgungskontakt zum Führen eines negativen Potentials einer Spannungsversorgung,
und mit einer Ruhestromquelle zur Beaufschlagung des Oszillators mit einem konstanten Ruhestrom, wobei ein erster Pol der Ruhestromquelle mit dem positiven Versorgungskontakt und ein zweiter Pol der Ruhestromquelle mit den Source-Anschlüssen der kreuzgekoppelten PMOS-Transistoren verbunden ist.

Der Begriff Weitband-Taktgeber betrifft dabei solche Taktgeber, welche über einen großen Frequenzbereich einstellbar sind.

Spannungsgesteuerte Oszillatoren, in der Fachsprache auch als Voltage Controlled Oscillator, abgekürzt VCO, bezeichnet, welche als aktive Elemente ausschließlich PMOS-Transistoren umfassen und folglich als All-PMOS-VCO bezeichnet werden, sind aus mehreren Publikationen bekannt.

In der Publikation "Dynamic Reconfigurable Si CMOS VCO", Takeshi lto u.a., ISBN: 978-1-4244-0748-4 ist eine typische PMOS-VCO-Struktur beschrieben.

In der DE 10 2005 006 543 ist ein direkt modulierter spannungsgesteuerter Oszillator auf CMOS-Basis offenbart. Dabei werden neben einer PMOS VCO Struktur variable Kapazitäten zur Modulation, aber auch zum Abgleich der Verstärkung, eingesetzt.

Der in dem Sammelband "Custom integrated Circuits Conference, 2003, Proceedings of the IEEE 2003" auf den Seiten 555-558 vorgestellte Artikel "A wideband low-phase-noise CMOS VCO" von Axel D. Berny u.a. zeigt einen weiteren CMOS VCO. Dieser CMOS VCO besteht ebenfalls aus PMOS Transistoren. Für das Tuning der Varaktoren (Kapazitätsdioden) sind über NMOS Transistoren geschaltete Kapazitäten eingesetzt, wodurch der zentrale Spannungspunkt zwischen den beiden symmetrischen Varaktoren einstellbar wird. Zwei Spulen sind symmetrisch gegen das negative Spannungspotential geschaltet.

Das US Patent US 6,542,043 offenbart einen weiteren PMOS VCO, bei dem ein Widerstand den zentralen Verbindungspunkt der Induktivitätsschaltung (Mittenabgriff der Spule) mit dem Grundpotential (negatives Potential einer Versorgungsspannung) verbindet.

Schließlich sei noch auf die Publikation vom Radio Frequency Integrated Circuits (RFIC) IEEE Symposium, 2000, Digest of Papers: "A fully integrated 5.35-GHz CMOS VCO and a prescaler" von Chih-Ming Hung u.a. hingewiesen. Darin wird eine PMOS VCO Struktur vorgestellt, welche eine zweite differentielle Verstärkerstufe aufweist. Darüber hinaus ist eine Frequenzhalbiererschaltung gezeigt, welche aus zwei D-Flipflops gebildet ist.

Nachteilig bei den bekannten Weitband-Taktgebern ist, dass der Energiebedarf insbesondere für mobile Anwendungen unerwünscht hoch ist.

Aufgabe der Erfindung ist es, einen Weitband-Taktgeber bereitzustellen, bei dem die Energieaufnahme verringert ist.

Die Aufgabe wird bei einem Weitband-Taktgeber der eingangs genannten Art dadurch gelöst, dass
ein einstellbarer Diodenblock vorgesehen ist, der eine Vielzahl von NMOS-Transistoren umfasst, welche jeweils einen Source-Anschluss, einen Drain-Anschluss und einen Gate-Anschluss aufweisen,
wobei deren Drain-Anschlüsse mit dem Mittenabgriff der Induktivitätsschaltung und deren Source-Anschlüsse mit dem wenigstens einen negativen Versorgungskontakt verbunden sind,
wobei jedem der NMOS-Transistoren jeweils eine Steuerschaltung zugeordnet ist, welche in Abhängigkeit eines binären Programmiersignals den jewei-
ligen Gate-Anschluss entweder niederohmig mit dem jeweiligen Drain-Anschluss oder mit dem jeweiligen Source-Anschluss verbindet.

Der erfindungsgemäße Weitband-Taktgeber ist in integrierter Bauweise ausgeführt, also als integrierter Schaltkreis, worunter verstanden wird, dass eine elektronische Schaltung, welche mehrere elektronische Bauelemente sowie eine zugehörige Verdrahtung umfasst, auf einem gemeinsamen Substrat, auch Chip genannt, ausgebildet ist. Dabei kann eine vollintegrierte Bauweise vorgesehen sein, bei der sämtliche elektronischen Bauelemente des Weitband-Taktgebers auf genau einem Substrat angeordnet sind.

Weiterhin ist der erfindungsgemäße Weitband-Taktgeber in CMOS-Technik gefertigt, worunter verstanden wird, dass sowohl PMOS-Transistoren, auch p-Kanal-Metalloxydhalbleiter-Transistoren genannt, als auch NMOS-Transistoren, auch n-Kanal- Metalloxydhalbleiter-Transistoren genannt, auf einem gemeinsamen Substrat angeordnet sein können.

Ebenso ist der erfindungsgemäße Weitband-Taktgeber differentiell aufgebaut. Unter einem differentiellen Aufbau wird ein derartiger Aufbau verstanden, bei dem die Eingänge und/oder Ausgänge einer Schaltung paarweise ausgeführt sind und weder mit einem positiven Versorgungspotential noch mit einem negativen Versorgungspotential einer die Schaltung versorgenden Versorgungsspannung verbunden sind. Unter "verbunden sein" wird im Rahmen der vorliegenden Anmeldung "elektrisch leitend verbunden sein" verstanden, soweit nichts anderes bestimmt ist.

Der Weitband-Taktgeber enthält einen differentiellen Oszillator zur Erzeugung eines differentiellen Oszillatorsignals. Der Oszillator weist hierzu einen Parallelschwingkreis auf, der durch die Kapazität einer Kapazitätsdiodenschaltung und eine Induktivität einer dazu parallel geschaltete Induktivitätsschaltung gebildet wird.

Um den so gebildeten Schwingkreis zu einer stabilen Schwingung anzuregen sind zwei kreuzgekoppelte PMOS-Transistoren vorgesehen, welche jeweils einen Source-Anschluss, einen Drain-Anschluss und einen Gate-Anschluss aufweisen. Unter Kreuzkopplung wird dabei verstanden, dass der Drain-Anschluss des einen Transistors mit dem Gate-Anschluss des anderen Transistors und umgekehrt verbunden ist. Durch die Verwendung von PMOS-Transistoren kann im Vergleich zur Verwendung von NMOS-Transistoren ein höheres Signal-Rausch-Verhältnis, ein geringeres Funkelrauschen, auch1/f-Rauschen oder flicker-noise genannt, sowie eine gute Isolierung gegenüber dem Substrat erzielt werden. Die Isolierung gegenüber dem Substrat kann hierbei insbesondere durch eine n-Wanne, auch n-well genannt, erzielt werden, worunter ein n-dotierter Bereich im ansonsten p-dotierten Substrat verstanden wird.

Die symmetrische Kapazitätsdiodenschaltung kann zwei in Reihe geschaltete Kapazitätsdioden umfassen, welche gegensätzlich gepolt sind, so dass die Kapazitätsdiodenschaltung Gleichstrom sperrt. Hierbei kann an der Verbindungsstelle der Kapazitätsdioden eine Steuerspannung angelegt werden, mittels derer die Kapazität der Kapazitätsdiodenschaltung und damit die Frequenz des Oszillators gesteuert und/oder geregelt werden kann. Ebenso kann die Kapazitätsdiodenschaltung eine Vollbrückenschaltung aufweisen, welche insbesondere vier Kapazitätsdioden aufweisen kann.

Die Induktivitätsschaltung weist einen Mittenabgriff auf, so dass die Induktivität der Induktivitätsschaltung aus zwei in Reihe geschalteten Teilinduktivitäten gleicher Größe besteht.

Die zwischen einem positiven Versorgungskontakt und einem negativen Versorgungskontakt durch eine Versorgungsspannungseinrichtung erzeugte Versorgungsspannung kann zwischen 1 und 2 Volt betragen.

Die Ruhestromquelle kann einen ersten Pol, der mit dem positiven Versorgungskontakt verbunden ist, und einen zweiten Pol, der mit den Source-Anschlüssen beider PMOS-Transistoren verbunden ist, aufweisen. Alternativ kann die Ruhestromquelle kann einen ersten Pol, der mit dem positiven Versorgungskontakt verbunden ist, und zwei zweite Pole, von denen jeder mit dem Source-Anschluss einer der beiden PMOS-Transistoren verbunden ist, aufweisen.

Erfindungsgemäß ist vorgesehen, dass die Drain-Anschlüsse wenigstens zweier NMOS-Transistoren des Diodenblocks mit dem Mittenabgriff der Induktivitätsschaltung und deren Source-Anschlüsse mit dem wenigstens einen negativen Versorgungskontakt verbunden sind. Dabei ist jedem der NMOS-Transistoren eine Steuerschaltung zugeordnet ist, welche in Abhängigkeit eines binären Programmiersignals den jeweiligen Gate-Anschluss entweder niederohmig mit dem jeweiligen Drain-Anschluss oder mit dem jeweiligen Source-Anschluss verbindet.

Wenn dabei der Gate-Anschluss mit dem Drain-Anschluss eines der NMOS-Transistoren niederohmig verbunden ist, so verhält sich der jeweilige NMOS-Transistor wie eine Diode, wovon sich der Begriff Diodenblock ableitet. Manchmal wird ein derartiger Diodenblock auch als NMOS-Block in Diodenschaltung (englisch: diode connected NMOS block) bezeichnet.

Die NMOS-Transistoren können selbstleitend, also leitend zwischen dem Source- und dem Drain-Anschluss, wenn keine Spannung zwischen dem Gate- und dem Drain-Anschluss anliegt, oder selbstsperrend, also sperrend zwischen dem Source- und dem Drain-Anschluss, wenn keine Spannung zwischen dem Gate- und dem Drain-Anschluss anliegt ausgebildet sein.

Wenn nun beispielsweise ein Gate-Anschluss eines der selbstsperrenden NMOS-Transistoren niederohmig mit dem Drain-Anschluss des jeweiligen NMOS-Transistors verbunden ist, so sperrt der betreffende NMOS-Transistor. Wenn allerdings ein Gate-Anschluss eines der NMOS-Transistoren niederohmig mit dem Source-Anschluss des jeweiligen NMOS-Transistors verbunden ist, so ist der betreffende NMOS-Transistor durchgeschaltet und verhält sich wie eine in Durchlassrichtung betriebene Diode.

Dabei kann der an dem Mittenabgriff der Induktivitätsschaltung abgegriffene Ruhestrom des Oszillators über diejenigen NMOS-Transistoren zum negativen Versorgungskontakt fließen, welche durchgeschaltet sind. Hierbei ist der durch den Ruhestrom erzeugte Spannungsabfall einerseits von den elektrischen Eigenschaften der verwendeten NMOS-Transistoren und andererseits von den an den Gate-Anschlüssen anliegenden binären Programmiersignalen abhängig. Durch die Vorgabe geeigneter binärer Programmiersignale ist es nun möglich, den Spannungsabfall am Diodenblock und hierdurch das Gleichspannungspotential der differentiellen Ausgangsanschlüsse einzustellen. Insbesondere ist es möglich, dass Gleichspannungspotential der differentiellen Ausgangsanschlüsse so zu beeinflussen, dass es unabhängig von der Frequenz des Oszillators ist.

Insbesondere ist das Gleichspannungspotential des differentiellen Oszillatorsignals so einstellbar, dass es unmittelbar, nämlich gleichspannungsgekoppelt, einer differentiellen Verarbeitungsschaltung, beispielsweise einem Frequenzteiler, zugeführt werden kann. Anders als bei den vorbekannten Taktgebern kann hierbei auf Schaltungen zur Entkopplung und/oder Aufbereitung des differentiellen Oszillatorsignals verzichtet werden.

Insbesondere kann auf Entkopplungs-Kondensatoren zur Gleichspannungsentkopplung zwischen dem Schwingkreis des Oszillators und der Verarbeitungsschaltung und/oder auf einen Zwischenverstärker zwischen dem Schwingkreis des Oszillators und der Verarbeitungsschaltung verzichtet werden. Hierdurch kann der Energiebedarf des Weitband-Taktgebers signifikant gesenkt werden. Gleichzeitig kann durch die fehlende Dämpfung durch Koppelkondensatoren eine größere Amplitude des Oszillatorsignals erreicht werden, so dass ein geringes Phasenrauschen erzielt werden kann. Ebenso kann der Flächenbedarf der Schaltung auf dem Substrat gesenkt werden.

Der Weitband-Taktgeber kann dabei so ausgebildet sein, dass er bis zu einigen GHz betriebsfähig ist.

Gemäß einer vorteilhaften Weiterbildung der Erfindung weisen die NMOS-Transistoren des Diodenblocks Transistorkanäle auf, deren Seitenverhältnisse zueinander binär gestaffelt sind. Die elektrischen Eigenschaften der NMOS-Transistoren des Diodenblocks werden insbesondere durch die Proportionen der Transistorkanäle, also durch deren Breite zu Länge Verhältnis bestimmt. Durch die Verwendung von binär gestaffelten Breite zu Länge Verhältnissen kann der einstellbare Bereich des Gleichspannungspotentials des differentiellen Oszillatorsignals im Vergleich zu solchen Lösungen gespreizt werden, bei denen sämtliche NMOS-Transistoren des Diodenblocks ein identisches Breite zu Länge Verhältnis aufweisen. Insbesondere können die Breite- zu Längsverhältnisse gemäß einer Folge 2⁰, 2¹, 2²,...,2ⁿ gestaffelt sein.

Nach einer vorteilhaften Weiterbildung der Erfindung weisen die NMOS-Transistoren des Diodenblocks Transistorkanäle auf, deren Seitenverhältnisse zueinander thermometrisch gestaffelt sind. Beispielsweise können die Breite- zu Längsverhältnisse gemäß einer Folge 1, 2, 3,...,n gestaffelt sein Auch in diesem Fall ergibt sich eine Spreizung des einstellbaren Bereichs des Gleichspannungspotentials des differentiellen Oszillatorsignals.

Gemäß einer vorteilhaften Weiterbildung der Erfindung sind die NMOS-Transistoren des Diodenblocks jeweils in einer tiefen N-Wanne gebildet. Unter einer tiefen N-Wanne, auch deep n-well genannt, wird eine Wanne verstanden welche tiefer als ein Mikrometer ist. Hierdurch kann eine besonders gute Isolierung gegenüber dem Substrat erzielt werden.

Nach einer vorteilhaften Weiterbildung der Erfindung umfasst die Steuerschaltungen für die NMOS-Transistoren jeweils zwei komplementär angesteuerte Schalter, von denen einer zwischen dem Drain-Anschluss und dem Gate-Anschluss und der andere zwischen dem Source-Anschluss und dem Gate-Anschluss des jeweiligen NMOS-Transistors angeordnet ist. Unter komplementärer Ansteuerung wird eine derartige Ansteuerung verstanden, dass jeweils einer der Schalter geöffnet und der jeweils andere Schalter geschlossen ist. Auf diese Weise ergibt sich eine besonders einfache Schaltung.

Nach einer zweckmäßigen Weiterbildung der Erfindung sind die Schalter zwei vorzugsweise in Sättigung betriebene NMOS-Schalttransistoren, wobei zwischen den Gate-Anschlüssen der NMOS-Schalttransistoren einer der Steuerschaltungen ein Inverter angeordnet ist. Durch die Verwendung eines Inverters ist in einfacher Weise sichergestellt, dass die Schalter stets komplementär angesteuert sind. Hierdurch sinkt der Energiebedarf weiter. Durch die Verwendung von NMOS-Schalttransistoren können die Schalter einfach realisiert werden, wobei der Sättigungsbetrieb eine besonders niederohmige Verbindung zwischen dem Drain-Anschluss und dem Gate-Anschluss bzw. zwischen dem Source-Anschluss und dem Gate-Anschluss des jeweiligen NMOS-Transistors ermöglicht.

Nach einer vorteilhaften Weiterbildung der Erfindung ist das der jeweiligen Steuerschaltung zugeordnete binäre Programmiersignal einem der Gate-Anschlüsse der jeweiligen NMOS-Schalttransistoren zugeführt. Hierdurch ergibt sich eine besonders einfache Schaltung, was auch einem geringen Energiebedarf zugute kommt.

Gemäß einer vorteilhaften Weiterbildung der Erfindung ist eine differentielle Verarbeitungsschaltung zum Verarbeiten des differentiellen Oszillatorsignals vorgesehen, welche zwei Eingangskontakte umfasst, welche jeweils mit einem Gate-Anschluss wenigstens eines Eingangs-NMOS-Transistors der Verarbeitungsschaltung verbunden sind, wobei die Ausgangsanschlüsse des Oszillators und die Eingangskontakte der Verarbeitungsschaltung gleichspannungsgekoppelt sind. Eine derartige Verarbeitungsschaltung weist einen hohen Eingangswiderstand auf, so dass der Schwingkreis des Oszillators nur gering belastet wird, was dessen Güte und dem Energieverbrauch des Weitband-Taktgebers dienlich ist.

Nach einer vorteilhaften Weiterbildung der Erfindung ist die Verarbeitungsschaltung ein Frequenzteiler. Ein Frequenzteiler ist eine Schaltung, welche aus einem Eingangssignal mit einer Eingangsfrequenz ein Ausgangssignal mit einer niedrigeren Ausgangsfrequenz teilt, wobei in der Regel ein ganzzahliges Teilungsverhältnis vorliegt. Auf diese Weise kann eine bestimmte Frequenz mit einem Schwingkreis mit vergleichsweise kleiner Kapazität und Induktivität erzeugt werden, was insbesondere den Platzbedarf des Weitband-Taktgebers senkt.

Gemäß einer vorteilhaften Weiterbildung der Erfindung der ist Frequenzteiler ein Frequenzhalbierer, der zwei differentielle D-Latch-Gatter umfasst, welche in Master-Slave Konfiguration mit negativer Rückkopplung angeordnet sind, wobei jedem der D-Latch-Gatter das differentielle Oszillatorsignal zugeführt ist, wobei jedes D-Latch-Gatter zwei Gattereingangs-NMOS-Transistoren aufweist, welche jeweils einen der besagten Eingangs-NMOS-Transistoren der Verarbeitungsschaltung bilden. Unter einem D-Latch-Gatter wird dabei ein taktzustandsgesteuertes D-Flipflop verstanden. Auf diese Weise kann mit einfachen Mitteln ein Teilung der Frequenz des Oszillators im Verhältnis 1 zu 2 erreicht werden.

Nach einer vorteilhaften Weiterbildung der Erfindung sind die Source-Anschlüsse der Gattereingangs-NMOS-Transistoren mit einem der negativen Versorgungskontakte verbunden, wodurch sich eine besonders einfache Schaltung ergibt.

Gemäß einer vorteilhaften Weiterbildung der Erfindung weisen die D-Latch-Gatter jeweils zwei Ausgänge auf, welche jeweils über einen Widerstand mit einem der positiven Versorgungskontakte verbunden sind. Auf diese Weise kann der Versorgungsstrom auf einfache Weise eingestellt werden.

Nach einer vorteilhaften Weiterbildung der Erfindung weisen die D-Latch-Gatter jeweils zwei Ausgänge auf, welche jeweils mit einem Drain-Anschluss eines PMOS-Transistors verbunden sind, der einen mit einem der negativen Versorgungskontakte verbundenen Gate-Anschluss und einen mit einem der positiven Versorgungskontakte verbundenen Source-Anschluss aufweist. Auch auf diese Weise kann der Versorgungsstrom auf einfache Weise eingestellt werden.

Gemäß einer vorteilhaften Weiterbildung der Erfindung umfasst die Ruhestromquelle einen PMOS-Transistor, der einen Source-Anschluss, einen Drain-Anschluss und einen Gate-Anschluss aufweist, wobei der Source-Anschluss mit dem ersten Pol der Ruhestromquelle verbunden ist, wobei der Drain-Anschluss mit dem zweiten Pol der Ruhestromquelle verbunden ist, und wobei der Gate-Anschluss mit einem Ausgang einer Versorgungsschaltung zum Einstellen des Ruhestroms des Oszillators verbunden ist. Durch eine derartige Ruhestromquelle wird eine gute Rauschunterdrückung gegenüber der Versorgungsspannung erreicht.

Nach einer vorteilhaften Weiterbildung der Erfindung weist die Induktivitätsschaltung in mindestens einer Metall-Schicht gebildete Induktivitätselemente auf, welche jeweils vorzugsweise als Spiralspulen ausgeführt sind. Auf diese Weise kann die Induktivitätsschaltung einfach und platzsparend hergestellt werden.

Die Erfindung und ihre Weiterbildungen wird anhand folgender Figuren näher erläutert. Es zeigen:
- **Figur 1**: einen spannungsgesteuerten Oszillator und einen Diodenblock eines Ausführungsbeispiel eines Weitband-Taktgebers,
- **Figur 2**: einen Frequenzteiler des Ausführungsbeispiels des Weitband-Taktgebers,
- **Figur 3**: eine erste Variante eines D-Latch-Gatters des Frequenzteilers aus Fig. 2
- **Figur 4**: eine alternative Variante eines D-Latch-Gatters des Frequenzteilers aus Fig. 2,
- **Figur 5**: eine detailliertere Darstellung des Diodenblocks aus Fig. 1 und
- **Figur 6**: die Gesamtschaltung des Ausführungsbeispiels mit D-Latch-Gattern gemäß der ersten Variante.

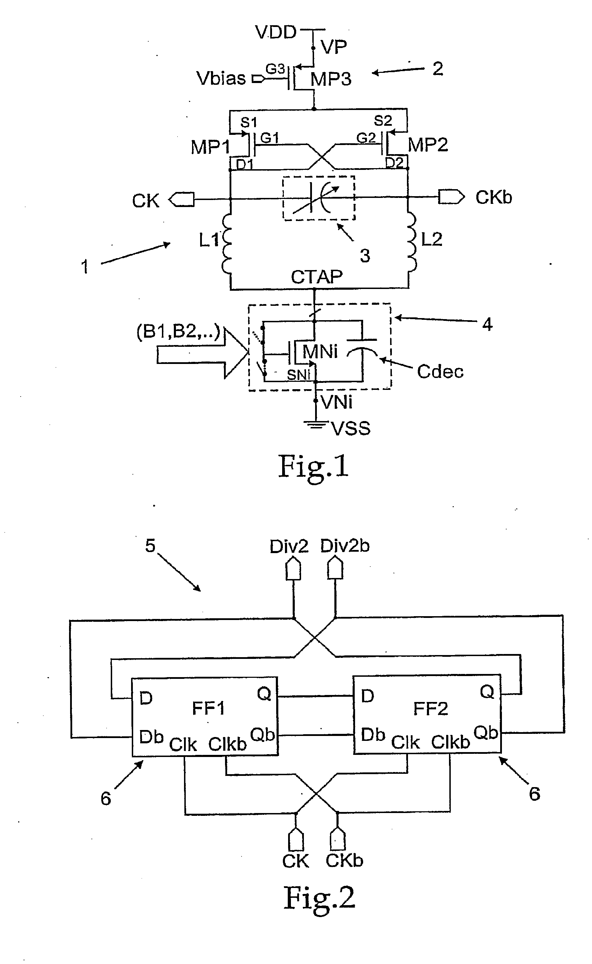

Figur 1 zeigt einen spannungsgesteuerten Oszillator 1 und einen Diodenblock 4 eines Ausführungsbeispiel eines Weitband-Taktgebers. Der erfindungsgemäße Weitband-Taktgeber ist in integrierter Bauweise ausgeführt, also als integrierter Schaltkreis, worunter verstanden wird, dass dessen elektronische Schaltung, welche mehrere elektronische Bauelemente sowie eine zugehörige Verdrahtung umfasst, auf einem gemeinsamen Substrat, auch Chip genannt, ausgebildet ist. Dabei kann eine vollintegrierte Bauweise vorgesehen sein, bei der sämtliche elektronischen Bauelemente des Weitband-Taktgebers auf genau einem Substrat angeordnet sind.

Weiterhin ist der erfindungsgemäße Weitband-Taktgeber in CMOS-Technik gefertigt, worunter verstanden wird, dass sowohl PMOS-Transistoren, auch p-Kanal-Metalloxydhalbleiter-Transistoren genannt, als auch NMOS-Transistoren, auch n-Kanal- Metalloxydhalbleiter-Transistoren genannt, auf einem gemeinsamen Substrat angeordnet sein können.

Ebenso ist der erfindungsgemäße Weitband-Taktgeber differentiell aufgebaut. Unter einem differentiellen Aufbau wird ein derartiger Aufbau verstanden, bei dem die Eingänge und/oder Ausgänge einer Schaltung paarweise ausgeführt sind und weder mit einem positiven Versorgungspotential VDD noch mit einem negativen Versorgungspotential VSS einer die Schaltung versorgenden Versorgungsspannung verbunden sind.

Der Weitband-Taktgeber enthält einen differentiellen Oszillator 1 zur Erzeugung eines differentiellen Oszillatorsignals. Der Oszillator weist hierzu einen Parallelschwingkreis L1, L2, 3 auf, der durch die Kapazität einer Kapazitätsdiodenschaltung 3 und eine Induktivität einer dazu parallel geschaltete Induktivitätsschaltung L1, L2 gebildet wird. Hierbei weist die Induktivitätsschaltung L1, L2 in einer Metall-Schicht gebildete Induktivitätselemente L1, L2 auf, welche jeweils vorzugsweise als Spiralspulen L1, L2 ausgeführt sind. Auf diese Weise kann die Induktivitätsschaltung L1, L2 einfach und platzsparend hergestellt werden.

Um den so gebildeten Schwingkreis L1, L2, 3 zu einer stabilen Schwingung anzuregen sind zwei kreuzgekoppelte PMOS-Transistoren MP1, MP2 vorgesehen, welche jeweils einen Source-Anschluss S1, S2, einen Drain-Anschluss D1, D2 und einen Gate-Anschluss G1, G2 aufweisen. Unter Kreuzkopplung wird dabei verstanden, dass der Drain-Anschluss D1 des ersten Transistors MP1 mit dem Gate-Anschluss G2 des anderen Transistors MP2 und umgekehrt verbunden ist. Durch die Verwendung von PMOS-Transistoren MP1, MP2 kann im Vergleich zur Verwendung von NMOS-Transistoren ein höheres Signal-Rausch-Verhältnis, ein geringeres Funkelrauschen, auch1/f-Rauschen oder flicker-noise genannt, sowie eine gute lsolierung gegenüber dem Substrat erzielt werden. Die Isolierung gegenüber dem Substrat kann hierbei insbesondere durch eine tiefe N-Wanne, auch n-well genannt, erzielt werden, worunter ein n-dotierter Bereich im ansonsten p-dotierten Substrat verstanden wird, die sich von der Oberfläche des Substrats mehr als einen Mikrometer in das Substrat hinein erstreckt.

Die symmetrische Kapazitätsdiodenschaltung 3 kann zwei in Reihe geschaltete Kapazitätsdioden umfassen, welche gegensätzlich gepolt sind, so dass die Kapazitätsdiodenschaltung Gleichstrom sperrt. Hierbei kann an der Verbindungsstelle der Kapazitätsdioden eine Steuerspannung angelegt werden, mittels derer die Kapazität der Kapazitätsdiodenschaltung und damit die Frequenz des Oszillators 1 gesteuert und/oder geregelt werden kann. Ebenso kann die Kapazitätsdiodenschaltung 3 eine Vollbrückenschaltung aufweisen, welche insbesondere vier Kapazitätsdioden umfassen kann.

Die Induktivitätsschaltung L1, L2 weist einen Mittenabgriff CTAP auf, so dass die Induktivität der Induktivitätsschaltung L1, L2 aus zwei in Reihe geschalteten Teilinduktivitäten L1, L2 gleicher Größe besteht.

Die Schaltung der Figur 1 umfasst einen positiven Versorgungskontakt VP zum Führen eines positiven Potentials VDD einer Spannungsversorgung sowie einen negativen Versorgungskontakt VNi zum Führen eines negativen Potentials VSS einer Spannungsversorgungseinrichtung Die zwischen dem positiven Versorgungskontakt VP und dem negativen Versorgungskontakt VNi durch eine Versorgungsspannungseinrichtung erzeugte VersorgungsSpannung kann zwischen 1 und 2 Volt betragen. Weiterhin umfasst der Oszillator 1 zwei Ausgangsanschlüsse CK, CKb zum Abgreifen des differentiellen Oszillatorsignals, welche jeweils mit einem der Drain-Anschlüsse D1, D2 der kreuzgekoppelten PMOS-Transistoren MP1, MP2 verbunden sind.

Die Ruhestromquelle 2 umfasst im Ausführungsbeispiel einen ersten Pol, der mit dem positiven Versorgungskontakt VP verbunden ist, und einen zweiten Pol, der mit den Source-Anschlüssen S1, S2 der beiden PMOS-Transistoren MP1, MP2 verbunden ist. Alternativ kann die Ruhestromquelle 2 kann einen ersten Pol, der mit dem positiven Versorgungskontakt VP verbunden ist, und zwei zweite Pole, von denen jeder mit dem Source-Anschluss S1, S2 einer der beiden PMOS-Transistoren MP1, MP2 verbunden ist, aufweisen.

In Figur 1 umfasst die Ruhestromquelle 2 einen PMOS-Transistor MP3, der einen Source-Anschluss, einen Drain-Anschluss und einen Gate-Anschluss G3 aufweist, wobei der Source-Anschluss mit dem ersten Pol der Ruhestromquelle 2 verbunden ist, wobei der Drain-Anschluss mit dem zweiten Pol der Ruhestromquelle 2 verbunden ist, und wobei der Gate-Anschluss G3 mit einem Ausgang Vbias einer Versorgungsschaltung zum Einstellen des Ruhestroms des Oszillators 1 verbunden ist. Durch eine derartige Ruhestromquelle 2 wird eine gute Rauschunterdrückung gegenüber der Versorgungsspannung erreicht.

Erfindungsgemäß ist vorgesehen, dass die Drain-Anschlüsse einer Vielzahl von NMOS-Transistoren MNi des Diodenblocks 4, von denen zur Vereinfachung in Figur 1 nur einer gezeigt ist, mit dem Mittenabgriff CTAP der Induktivitätsschaltung L1, L2 und deren Source-Anschlüsse mit dem negativen Versorgungskontakt VNi verbunden sind. Dabei ist jedem der NMOS-Transistoren MNi eine Steuerschaltung zugeordnet, welche in Abhängigkeit eines binären Programmiersignals B1, B2,... den jeweiligen Gate-Anschluss entweder niederohmig mit dem jeweiligen Drain-Anschluss oder mit dem jeweiligen Source-Anschluss verbindet.

Figur 2 zeigt eine differentielle Verarbeitungsschaltung 5 zum Verarbeiten des differentiellen Oszillatorsignals des beispielhaften Weitband-Taktgebers, welche zwei Eingangskontakte umfasst, welche zum Verbinden mit den Ausgangsanschlüssen CK, CKb zum Abgreifen des differentiellen Oszillatorsignals vorgesehen sind. Die Verarbeitungsschaltung 5 ist als Frequenzteiler 5, nämlich als Frequenzhalbierer 5, ausgebildet. Ein Frequenzhalbierer 5 ist eine Schaltung, welche aus einem Eingangssignal mit einer Eingangsfrequenz ein Ausgangssignal mit halber Ausgangsfrequenz erzeugt. Auf diese Weise kann eine bestimmte Frequenz mit einem Schwingkreis mit vergleichsweise kleiner Kapazität und Induktivität erzeugt werden, was insbesondere den Platzbedarf des Weitband-Taktgebers senkt.

Der Frequenzhalbierer 5 umfasst zwei gleichartige D-Latch-Gatter 6, welche jeweils differentielle Takteingänge Clk, ClKb, differentielle Digitalsignal-Eingänge D, Db und differentielle Digitalsignal-Ausgänge Q, Qb aufweisen. Unter einem D-Latch-Gatter 6 wird dabei ein taktzustandsgesteuertes D-Flipflop 6 verstanden. Auf diese Weise kann mit einfachen Mitteln ein Teilung der Frequenz des Oszillators 1 im Verhältnis 1 zu 2 erreicht werden.

Das differentielle Ausgangssignal des Oszillatorsignals liegt dabei an den differentiellen Takteingängen Clk, ClKb beider D-Latch-Gatter 6 an. Die zwei differentiellen D-Latch-Gatter 6 sind in Master-Slave Konfiguration mit negativer Rückkopplung angeordnet, wobei der differentielle Eingang D, Db des einen D-Latch-Gatters 6 ungekreuzt mit dem differentiellen Ausgang Q, Qb des anderen D-Latch-Gatters 6 und der differentielle Ausgang Q, Qb des einen D-Latch-Gatters 6 gekreuzt mit dem differentiellen Eingang D, Db des anderen D-Latch-Gatters 6 verbunden ist.

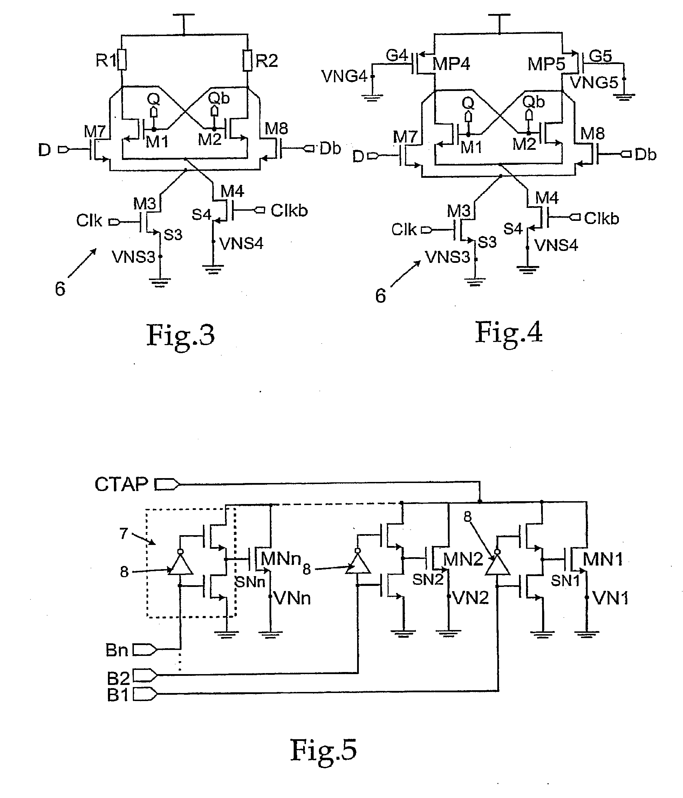

Figur 3 zeigt eine erste Variante eines D-Latch-Gatters 6 des Frequenzteilers 5 aus der Fig. 2. Das D-Latch-Gatter 6 weist zwei Gattereingangs-NMOS-Transistoren M3, M4 auf, welche jeweils einen Eingangs-NMOS-Transistor der Verarbeitungsschaltung 5 bilden. Eine derartige Verarbeitungsschaltung 5 weist einen hohen Eingangswiderstand auf, so dass der Schwingkreis des Oszillators 1 nur gering belastet wird, was dessen Güte und dem Energieverbrauch des Weitband-Taktgebers dienlich ist.

Dabei sind die Source-Anschlüsse der Gattereingangs-NMOS-Transistoren M3, M4 jeweils mit einem der negativen Versorgungskontakte VNS3, VNS4 verbunden, wodurch sich eine besonders einfache Schaltung ergibt. Weiterhin weist das D-Latch-Gatter 6 zwei Ausgänge Q, Qb auf, welche jeweils über einen Widerstand R1, R2 mit einem der positiven Versorgungskontakte verbunden sind. Auf diese Weise kann der Versorgungsstrom auf einfache Weise eingestellt werden.

Figur 4 zeigt eine alternative Variante eines D-Latch-Gatters des Frequenzteilers aus Fig. 2, bei der das D-Latch-Gatter 6 jeweils zwei Ausgänge Q, Qb aufweist, welche jeweils mit einem Drain-Anschluss eines PMOS-Transistors MP4, MP5 verbunden sind, der einen mit einem der negativen Versorgungskontakte VNG4, VNG5 verbundenen Gate-Anschluss G4, G5 und einen mit einem der positiven Versorgungskontakte verbundenen Source-Anschluss aufweist. Auch auf diese Weise kann der Versorgungsstrom auf einfache Weise eingestellt werden.

Figur 5 zeigt eine detailliertere Darstellung des Diodenblocks aus Fig. 1. Dargestellt ist eine Vielzahl von NMOS-Transistoren MN1, MN2,...,MNn, deren Drain-Anschlüsse mit dem Mittenabgriff CTAP der Induktivitätsschaltung L1, L2 und deren Source-Anschlüsse SN1, SN2,...SNn mit einem negativen Versorgungskontakt VN1, VN2,...VNn verbunden sind.

Die NMOS-Transistoren MN1, MN2,...,MNn können selbstleitend, also leitend zwischen dem Source- SN1, SN2,...SNn und dem Drain-Anschluss, wenn keine Spannung zwischen dem Gate- und dem Drain-Anschluss anliegt, oder selbstsperrend, also sperrend zwischen dem Source- und dem Drain-Anschluss, wenn keine Spannung zwischen dem Gate- und dem Drain-Anschluss anliegt ausgebildet sein.

Wenn nun wie im Ausführungsbeispiel ein Gate-Anschluss eines der selbstsperrenden NMOS-Transistoren MN1, MN2,...,MNn niederohmig mit dem Drain-Anschluss des jeweiligen NMOS-Transistors verbunden ist, so sperrt der betreffende NMOS-Transistor MN1, MN2,...,MNn. Wenn allerdings ein Gate-Anschluss eines der NMOS-Transistoren MN1, MN2,...,MNn niederohmig mit dem Source-Anschluss SN1, SN2,...,SNn des jeweiligen NMOS-Transistors MN1, MN2,...,MNn verbunden ist, so ist der betreffende NMOS-Transistor MN1, MN2,...,MNn durchgeschaltet und verhält sich wie eine in Durchlassrichtung betriebene Diode.

Dabei kann der an dem Mittenabgriff CTAP der Induktivitätsschaltung L1, L2 abgegriffene Ruhestrom des Oszillators 1 über diejenigen NMOS-Transistoren MN1, MN2,...,MNn zum negativen Versorgungskontakt fließen, welche durchgeschaltet sind. Hierbei ist der durch den Ruhestrom erzeugte Spannungsabfall einerseits von den elektrischen Eigenschaften der verwendeten NMOS-Transistoren MN1, MN2,...,MNn und andererseits von den an den Gate-Anschlüssen anliegenden binären Programmiersignalen B1, B2,...Bn abhängig. Durch die Vorgabe geeigneter binärer Programmiersignale B1, B2,...Bn ist es nun möglich, den Spannungsabfall am Diodenblock 4 und hierdurch das Gleichspannungspotential der differentiellen Ausgangsanschlüsse CK, CKb einzustellen. Insbesondere ist es möglich, dass Gleichspannungspotential der differentiellen Ausgangsanschlüsse CK, CKb so zu beeinflussen, dass es unabhängig von der Frequenz des Oszillators 1 ist.

Die NMOS-Transistoren MN1, MN2,...,MNn des Diodenblocks 4 können Transistorkanäle aufweisen, deren Seitenverhältnisse zueinander binär gestaffelt sind. Die elektrischen Eigenschaften der NMOS-Transistoren MN1, MN2,...,MNn des Diodenblocks 4 werden insbesondere durch die Proportionen der Transistorkanäle, also durch deren Breite zu Länge Verhältnis bestimmt. Durch die Verwendung von binär gestaffelten Breite zu Länge Verhältnissen kann der einstellbare Bereich des Gleichspannungspotentials des differentiellen Oszillatorsignals im Vergleich zu solchen Lösungen gespreizt werden, bei denen sämtliche NMOS-Transistoren MN1, MN2,...,MNn des Diodenblocks 4 ein identisches Breite zu Länge Verhältnis aufweisen. Insbesondere können die Breite- zu Längsverhältnisse gemäß einer Folge 20, 21, 22,...,2n gestaffelt sein. Ebenso können die NMOS-Transistoren MN1, MN2,...,MNn des Diodenblocks 4 Transistorkanäle aufweisen, deren Seitenverhältnisse zueinander thermometrisch gestaffelt sind. Beispielsweise können die Breite- zu Längsverhältnisse gemäß einer Folge 1, 2, 3,...,n gestaffelt sein Auch in diesem Fall ergibt sich eine Spreizung des einstellbaren Bereichs des Gleichspannungspotentials des differentiellen Oszillatorsignals. Dabei können die NMOS-Transistoren MN1, MN2,...,MNn des Diodenblocks 4 jeweils in einer tiefen N-Wanne gebildet sein. Unter einer tiefen N-Wanne, auch deep n-well genannt, wird eine Wanne verstanden welche tiefer als ein Mikrometer ist. Hierdurch kann eine besonders gute Isolierung gegenüber dem Substrat erzielt werden.

Dabei ist jedem der NMOS-Transistoren MN1, MN2,...,MNn eine Steuerschaltung 7 zugeordnet, welche in Abhängigkeit eines binären Programmiersignals B1, B2,..., Bn den jeweiligen Gate-Anschluss entweder niederohmig mit dem jeweiligen Drain-Anschluss oder mit dem jeweiligen Source-Anschluss SN1, SN2,...,SNn verbindet.

Die Steuerschaltungen 7 für die NMOS-Transistoren MN1, MN2,...,MNn umfassen jeweils zwei komplementär angesteuerte Schalter, von denen einer zwischen dem Drain-Anschluss und dem Gate-Anschluss und der andere zwischen dem Source-Anschluss SN1, SN2,...,SNn und dem Gate-Anschluss des jeweiligen NMOS-Transistors MN1, MN2,...,MNn angeordnet ist. Unter komplementärer Ansteuerung wird eine derartige Ansteuerung verstanden, dass jeweils einer der Schalter geöffnet und der jeweils andere Schalter geschlossen ist. Auf diese Weise ergibt sich eine besonders einfache Schaltung.

Im Ausführungsbeispiel sind die Schalter zwei in Sättigung betriebene NMOS-Schalttransistoren, wobei zwischen den Gate-Anschlüssen der NMOS-Schalttransistoren einer der Steuerschaltungen 7 ein Inverter 8 angeordnet ist. Durch die Verwendung eines Inverters 8 ist in einfacher Weise sichergestellt, dass die Schalter stets komplementär angesteuert sind. Hierdurch sinkt der Energiebedarf weiter. Durch die Verwendung von NMOS-Schalttransistoren können die Schalter einfach realisiert werden, wobei der Sättigungsbetrieb eine besonders niederohmige Verbindung zwischen dem Drain-Anschluss und dem Gate-Anschluss bzw. zwischen dem Source-Anschluss und dem Gate-Anschluss des jeweiligen NMOS-Transistors ermöglicht.

Dabei ist vorteilhafterweise das der jeweiligen Steuerschaltung 7 zugeordnete binäre Programmiersignal B1, B2,...Bn einem der Gate-Anschlüsse der jeweiligen NMOS-Schalttransistoren zugeführt. Hierdurch ergibt sich eine besonders einfache Schaltung, was auch einem geringen Energiebedarf zugute kommt.

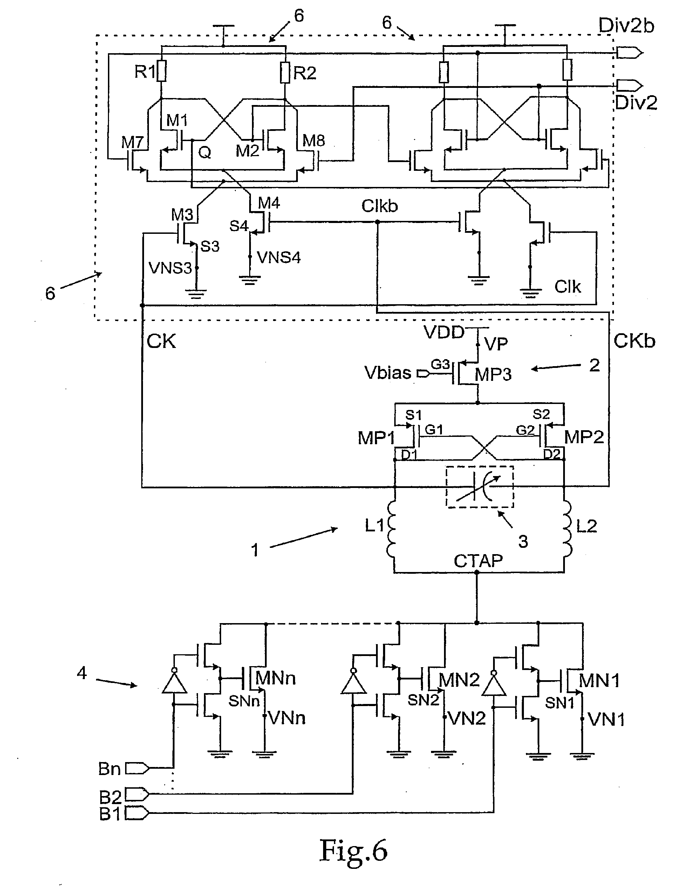

Figur 6 zeigt die Gesamtschaltung des Ausführungsbeispiels mit D-Latch-Gattern 6 gemäß der ersten Variante, wobei insbesondere ersichtlich ist, dass die Ausgangsanschlüsse CK, CKb des Oszillators 1 und die Eingangskontakte der Verarbeitungsschaltung 5 gleichspannungsgekoppelt sind. Durch die Vorgabe geeigneter binärer Programmiersignale B1, B2,..., Bn ist es nun möglich, den Spannungsabfall am Diodenblock 4 und hierdurch das Gleichspannungspotential der differentiellen Ausgangsanschlüsse CK, CKb einzustellen. Insbesondere ist es möglich, dass Gleichspannungspotential der differentiellen Ausgangsanschlüsse CK, CKb so zu beeinflussen, dass es unabhängig von der Frequenz des Oszillators 1 ist. Anders als bei den vorbekannten Taktgebern kann hierbei auf Schaltungen zur Entkopplung und/oder Aufbereitung des differentiellen Oszillatorsignals verzichtet werden. Insbesondere kann auf Entkopplungs-Kondensatoren zur Gleichspannungsentkopplung zwischen dem Schwingkreis L1, L2, 3 des Oszillators 1 und der Verarbeitungsschaltung 5 und/oder auf einen Zwischenverstärker zwischen dem Schwingkreis L1, L2, 3 des Oszillators 1 und der Verarbeitungsschaltung 5 verzichtet werden. Hierdurch kann der Energiebedarf des Weitband-Taktgebers signifikant gesenkt werden. Gleichzeitig kann durch die fehlende Dämpfung durch Koppelkondensatoren eine größere Amplitude des Oszillatorsignals erreicht werden, so dass ein geringes Phasenrauschen erzielt werden kann. Ebenso kann der Flächenbedarf der Schaltung auf dem Substrat gesenkt werden. Der Breitand-Taktgeber kann dabei so ausgebildet sein, dass er bis zu einigen GHz betriebsfähig ist.

### Bezugszeichenliste

- 1: spannungsgesteuerter Oszillator
- 2: Ruhestromquelle
- 3: symmetrisch Kapazitätsdiodenstruktur
- 4: programmierbarer Diodenblock
- 5: Verarbeitungsschaltung, Frequenzhalbierer
- 6: D-Latch-Gatter
- 7: Steuerschaltung zum aktivieren oder deaktivieren der als Diodenkombination konfigurierbaren NMOS-Transistoren
- 8: CMOS-Inverter
- VDD: positives Versorgungsspannungs-Potential
- VSS: negatives Versorgungsspannungs-Potential
- Vbias: Ausgang einer Versorgungsschaltung zum Einstellen des Ruhestroms des Oszillators
- VP: positiver Versorgungskontakt
- VN: negativer Versorgungskontakt
- MP: PMOS-Transistor
- MN: als Diodenkombination konfigurierbarer NMOS-Transistor
- CK, CKb: Ausgangsanschlüsse (CK, CKb) zum Abgreifen des differentiellen Oszillatorsignals
- B: digitales Programmiersignal für den Diodenblock
- L1, L2: Induktivitätselemente, insbesondere Spiralspulen,
- CTAP: Mittenabgriff der Induktivitätsschaltung
- S: Source-Anschlüsse der Transistoren
- G: Gate-Anschlüsse der Transistoren
- Cdec: Kapazität des Diodenblocks
- Div2, Div2b: differentielles Ausgangssignal des Frequenzhalbierers
- R1,R2: Ohmsche Widerstände
- M: NMOS-Transistor in den D-Latch-Gattern
- Clk, Clkb: differentieller Takt-Eingang der D-Latch-Gatter
- D, Db: differentieller Digitalsignal-Eingang der D-Latch-Gatter
- Q, Qb: differentieller Digitalsignal-Ausgang der D-Latch-Gattern.

## Patentansprüche

1. CMOS-integrierter, differentiell aufgebauter Weitband-Taktgeber
mit einem spannungsgesteuertem Oszillator (1) zum Erzeugen eines differentiellen Oszillatorsignals, umfassend zwei kreuzgekoppelte PMOS-Transistoren (MP1, MP2), welche jeweils einen Source-Anschluss (S1, S2), einen Drain-Anschluss (D1, D2) und einen Gate-Anschluss (G1, G2) aufweisen, weiter umfassend eine symmetrische Kapazitätsdiodenschaltung (3), welche eine durch eine Steuerspannung einstellbare Kapazität aufweist, welche zwischen den beiden Drain-Anschlüssen (D1, D2) der kreuzgekoppelten PMOS-Transistoren (MP1, MP2) wirkt, weiter umfassend eine zur Kapazitätsdiodenschaltung (3) parallel geschaltete Induktivitätsschaltung (L1, L2), welche einen Mittenabgriff (CTAP) aufweist, und weiter umfassend zwei Ausgangsanschlüsse (CK, CKb) zum Abgreifen des differentiellen Oszillatorsignals, welche jeweils mit einem der Drain-Anschlüsse (D1, D2) der kreuzgekoppelten PMOS-Transistoren (MP1, MP2) verbunden sind
mit wenigstens einem positiven Versorgungskontakt (VP) zum Führen eines positiven Potentials (VDD) einer Spannungsversorgung,
mit wenigstens einem negativen Versorgungskontakt (VNi; VN1, VN2,..,VNn; VNS3, VNS4; VNG4, VNG5) zum Führen eines negativen Potentials (VSS) einer Spannungsversorgungseinrichtung,
und mit einer Ruhestromquelle (2) zur Beaufschlagung des Oszillators (1) mit einem konstanten Ruhestrom, wobei ein erster Pol der Ruhestromquelle (2) mit dem positiven Versorgungskontakt (VP) und ein zweiter Pol der Ruhestromquelle (2) mit den Source-Anschlüssen (S1, S2) der kreuzgekoppelten PMOS-Transistoren (MP1, MP2) verbunden ist,
**dadurch gekennzeichnet, dass**
ein einstellbarer Diodenblock (4) vorgesehen ist, der eine Vielzahl von NMOS-Transistoren (MNi; MN1, MN2,...,MNn) umfasst, welche jeweils einen Source-Anschluss (SNi; SN1, SN2, SNn), einen Drain-Anschluss und einen Gate-Anschluss aufweisen,
wobei deren Drain-Anschlüsse mit dem Mittenabgriff (CTAP) der Induktivitätsschaltung (L1, L2) und deren Source-Anschlüsse (SNi; SN1, SN2,...,SNn) mit dem wenigstens einen negativen Versorgungskontakt (VNi; VN1, VN2,..,VNn) verbunden sind,
wobei jedem der NMOS-Transistoren (MNi; MN1, MN2,...,MNn) jeweils eine Steuerschaltung (7) zugeordnet ist, welche in Abhängigkeit eines binären Programmiersignals (B1, B2,..,BN) den jeweiligen Gate-Anschluss entweder niederohmig mit dem jeweiligen Drain-Anschluss oder mit dem jeweiligen Source-Anschluss (SNi; SN1, SN2, SNn) verbindet.

2. Weitband-Taktgeber nach einem der vorstehenden Ansprüche, **dadurch gekennzeichnet, dass** die NMOS-Transistoren (MNi; MN1, MN2,...,MNn) des Diodenblocks (4) Transistorkanäle aufweisen, deren Seitenverhältnisse zueinander binär gestaffelt sind.

3. Weitband-Taktgeber nach einem der vorstehenden Ansprüche, **dadurch gekennzeichnet, dass** die NMOS-Transistoren (MNi; MN1, MN2,...,MNn) des Diodenblocks (4) Transistorkanäle aufweisen, deren Seitenverhältnisse zueinander thermometrisch gestaffelt sind.

4. Weitband-Taktgeber nach einem der vorstehenden Ansprüche, **dadurch gekennzeichnet, dass** die NMOS-Transistoren (MNi; MN1, MN2,...,MNn) des Diodenblocks (4) jeweils in einer tiefen N-Wanne gebildet sind.

5. Weitband-Taktgeber nach einem der vorstehenden Ansprüche, **dadurch gekennzeichnet, dass** die Steuerschaltungen (7) für die NMOS-Transistoren (MN1, MN2,..,MNn) jeweils zwei komplementär angesteuerte Schalter umfasst, von denen einer zwischen dem Drain-Anschluss und dem Gate-Anschluss und der andere zwischen dem Source-Anschluss und dem Gate-Anschluss des jeweiligen NMOS-Transistors angeordnet ist.

6. Weitband-Taktgeber nach vorstehendem Anspruch, **dadurch gekennzeichnet, dass** die Schalter zwei vorzugsweise in Sättigung betriebene NMOS-Schalttransistoren sind, wobei zwischen den Gate-Anschlüssen der NMOS-Schalttransistoren einer der Steuerschaltungen (7) ein Inverter (8) angeordnet ist.

7. Weitband-Taktgeber nach vorstehendem Anspruch, **dadurch gekennzeichnet, dass** das der jeweiligen Steuerschaltung (7) zugeordnete binäre Programmiersignal (B1, B2,..,BN) einem der Gate-Anschlüsse der jeweiligen NMOS-Schalttransistoren zugeführt ist.

8. Weitband-Taktgeber nach einem der vorstehenden Ansprüche, **dadurch gekennzeichnet, dass** eine differentielle Verarbeitungsschaltung (5) zum Verarbeiten des differentiellen Oszillatorsignals vorgesehen ist, welche zwei Eingangskontakte (Clk, Clkb) umfasst, welche jeweils mit einem Gate-Anschluss wenigstens eines Eingangs-NMOS-Transistors (M3, M4) der Verarbeitungsschaltung (5) verbunden sind, wobei die Ausgangsanschlüsse (CK, CKb) des Oszillators (1) und die Eingangskontakte (Clk, Clkb) der Verarbeitungsschaltung (5) gleichspannungsgekoppelt sind.

9. Weitband-Taktgeber nach vorstehendem Anspruch, **dadurch gekennzeichnet, dass** die Verarbeitungsschaltung (5) ein Frequenzteiler (5) ist.

10. Weitband-Taktgeber nach vorstehendem Anspruch, **dadurch gekennzeichnet, dass** der Frequenzteiler (5) ein Frequenzhalbierer (5) ist, der zwei differentielle D-Latch-Gatter (6) umfasst, welche in Master-Slave Konfiguration mit negativer Rückkopplung angeordnet sind, wobei jedem der D-Latch-Gatter (6) das differentielle Oszillatorsignal zugeführt ist, wobei jedes D-Latch-Gatter (6) zwei Gattereingangs-NMOS-Transistoren (M3, M4) aufweist, welche jeweils einen der besagten Eingangs-MOS-Transistoren (M3, M4) der Verarbeitungsschaltung (5) bilden.

11. Weitband-Taktgeber nach vorstehendem Anspruch, **dadurch gekennzeichnet, dass** die Source-Anschlüsse (S3, S4) der Gattereingangs-NMOS-Transistoren (M3, M4) mit einem der negativen Versorgungskontakte (VNS3, VNS4) verbunden sind.

12. Weitband-Taktgeber nach einem der Ansprüche 10 oder 11, **dadurch gekennzeichnet, dass** die D-Latch-Gatter (6) jeweils zwei Ausgänge (Q, Qb) aufweisen, welche jeweils über einen Widerstand (R1, R2) mit einem der positiven Versorgungskontakte verbunden sind.

13. Weitband-Taktgeber nach einem der Ansprüche 10 oder 11, **dadurch gekennzeichnet, dass** die D-Latch-Gatter (6) jeweils zwei Ausgänge (Q, Qb) aufweisen, welche jeweils mit einem Drain-Anschluss eines PMOS-Transistors (MP4, MP5) verbunden sind, der einen mit einem der negativen Versorgungskontakte (VNG4, VNG5) verbundenen Gate-Anschluss und einen mit einem der positiven Versorgungskontakte verbundenen Source-Anschluss aufweist.

14. Weitband-Taktgeber nach einem der vorstehenden Ansprüche, **dadurch gekennzeichnet, dass** die Ruhestromquelle (2) einen PMOS-Transistor (MP3) umfasst, der einen Source-Anschluss, einen Drain-Anschluss und einen Gate-Anschluss (G3) aufweist, wobei der Source-Anschluss mit dem ersten Pol der Ruhestromquelle (2) verbunden ist, wobei der Drain-Anschluss mit dem zweiten Pol der Ruhestromquelle (2) verbunden ist, und wobei der Gate-Anschluss (G3) mit einem Ausgang (Vbias) einer Versorgungsschaltung zum Einstellen des Ruhestroms des Oszillators (1) verbunden ist.

15. Weitband-Taktgeber nach einem der vorstehenden Ansprüche, **dadurch gekennzeichnet, dass** die Induktivitätsschaltung (L1, L2) in mindestens einer Metall-Schicht gebildete Induktivitätselemente (L1, L2) aufweist, welche jeweils vorzugsweise als Spiralspulen (L1, L2) ausgeführt sind.

## Claims

1. A CM0S-integrated differentially constructed wideband clock pulse generator
having a voltage-controlled oscillator (1) for generating a differential oscillator signal, comprising two cross-coupled PMOS transistors (MP1, MP2) each having a source terminal (S1, S2), a drain terminal (D1, D2), and a gate terminal (G1, G2), further comprising a symmetrical capacitance diode circuit (3) provided with a capacitance variable by a control voltage and acting between the two drain terminals (D1, D2) of the cross-coupled PMOS transistors (MP1, MP2), further comprising an inductive circuit (L1, L2) connected in parallel with the capacitance diode circuit (3) and having a center tap (CTAP), and further comprising two output terminals (CK, CKb) for tapping the differential oscillator signal, each connected to one of the drain terminals (D1, D2) of the cross-coupled PMOS transistors (MP1, MP2),
having at least one positive supply contact (VP) for carrying a positive potential (VDD) of a power supply,
having at least one negative supply contact (VNi; VN1, VN2, ..,VNn; VNS3, VNS4; VNG4, VNG5) for carrying a negative potential (VSS) of a power supply device,
and having a bias current source (2) for supplying a constant bias current to the oscillator, a first pole of the bias current source (2) being connected to the positive supply contact (VP) and a second pole of the bias current source (2) being connected to the source terminals (S1, S2) of the cross-coupled PMOS transistors (MP1, MP2), **characterized in that**
an adjustable diode block (4) is provided, comprising a plurality of NMOS transistors (MNi; MN1, MN2,...,MNn), each comprising a source terminal (SNi; SN1, SN2, SNn), a drain terminal and a gate terminal,
wherein the drain terminals thereof are connected to the center tap (CTAP) of the inductivity circuit (L1, L2) and the source terminals thereof (SNi; SN1, SN2,..., SNn) are connected to the at least one negative supply contact (VNi; VN1, VN2, .., VNn),
wherein each of the NMOS transistors (MNi; MN1, MN2,...,MNn) is associated with a control circuit (7) connecting the corresponding gate terminal either to the corresponding drain terminal at a low resistance or to the corresponding source terminal (SNi; SN1, SN2, SNn) depending on a binary programming signal (B1, B2,..,BN).

2. The wideband clock according to any one of the preceding claims, **characterized in that** the NMOS transistors (MNi; MN1, MN2,..., MNn) of the diode block (4) comprise transistor channels having aspect ratios graduated in a binary relationship to each other.

3. The wideband clock according to any one of the preceding claims, **characterized in that** the NMOS transistors (MNi; MN1, MN2,..., MNn) of the diode block (4) comprise transistor channels having aspect ratios graduated thermometrically relative to each other.

4. The wideband clock according to any one of the preceding claims, **characterized in that** the NMOS transistors (MNi; MN1, MN2,..., MNn) of the diode block (4) are each implemented in a deep N-well.

5. The wideband clock according to any one of the preceding claims, **characterized in that** the control circuits (7) for the NMOS transistors (MN1, MN2,.., MNn) each comprise two complementarily controlled switches, of which one is disposed between the drain terminal and the gate terminal and the other is disposed between the source terminal and the gate terminal of the corresponding NMOS transistor.

6. The wideband clock according to the preceding claim, **characterized in that** the switches are two NMOS switching transistors preferably operated at saturation, wherein an inverter (8) is disposed between the gate terminals of the NMOS switching transistors of one of the control circuits (7).

7. The wideband clock according to the preceding claim, **characterized in that** the binary programming signal (B1, B2,.., BN) associated with the corresponding control circuit (7) is fed to one of the gate terminals of the corresponding NMOS switching transistors.

8. The wideband clock according to any one of the preceding claims, **characterized in that** a differential processing circuit (5) is provided for processing the differential oscillator signal, comprising two input contacts (Clk, Clkb), each connected to a gate terminal of at least one input NMOS transistor (M3, M4) of the processing circuit (5), wherein the output terminals (CK, CKb) of the oscillator (1) and the input contacts (Clk, Clkb) of the processing circuit (5) are DC-coupled.

9. The wideband clock according to the preceding claim, **characterized in that** the processing circuit (5) is a frequency divider (5).

10. The wideband clock according to the preceding claim, **characterized in that** the frequency divider (5) is a frequency halver (5) comprising two differential D-latch gates (6) disposed in a master-slave configuration with negative feedback, wherein the differential oscillator signal is fed to each of the D-latch gates (6), wherein each D-latch gate (6) comprises two gate input NMOS transistors (M3, M4), each forming one of said input MOS transistors (M3, M4) of the processing circuit (5).

11. The wideband clock according to the preceding claim, **characterized in that** the source terminals (S3, S4) of the gate input NMOS transistors (M3, M4) are connected to one of the negative supply contacts (VNS3, VNS4).

12. The wideband clock according to any one of the claims 10 or 11, **characterized in that** the D-latch gates (6) each comprise two outputs (Q, Qb), each connected to one of the positive supply contacts by means of a resistor (R1, R2).

13. The wideband clock according to any one of the claims 10 or 11, **characterized in that** the D-latch gates (6) each comprise two outputs (Q, Qb), each connected to a drain terminal of a PMOS transistor (MP4, MP5) comprising a gate terminal connected to one of the negative supply contacts (VNG4, VNG5) and a source terminal connected to one of the positive supply contacts.

14. The wideband clock according to any one of the preceding claims, **characterized in that** the bias current source (2) comprises a PMOS transistor (MP3) having a source terminal, a drain terminal, and a gate terminal (G3), wherein the source terminal is connected to the first pole of the bias current source (2), wherein the drain terminal is connected to the second pole of the bias current source (2), and wherein the gate terminal (G3) is connected to an output (Vbias) of a supply circuit for adjusting the bias current of the oscillator (1).

15. The wideband clock according to any one of the preceding claims, **characterized in that** the inductivity circuit (L1, L2) comprises inductivity elements (L1, L2) implemented in at least one metal layer, each preferably implemented as spiral coils (L1, L2).

## Revendications

1. Générateur d'horloge à bande large à configuration différentielle intégré CMOS,
avec un oscillateur commandé en tension (1) pour générer un signal d'oscillateur différentiel, comprenant deux transistors PMOS couplés transversalement (MP1, MP2), lesquels présentent respectivement une borne Source (S1, S2), une borne Drain (D1, D2) et une borne Gate (G1, G2), comprenant en outre un circuit de diode à capacité variable (3), lequel présente une capacité réglable via une tension de commande, laquelle agit entre les deux bornes Drain (D1, D2) des transistors PMOS couplés transversalement (MP1, MP2), comprenant en outre un circuit d'inductivité (L1, L2) branché parallèlement au circuit de diode à capacité variable (3), qui présente une prise intermédiaire (CTAP), et comportant en outre deux bornes de sortie (CK, CKb) pour prélever le signal d'oscillateur différentiel, qui sont respectivement reliés avec l'une des bornes Drain (D1, D2) des transistors PMOS couplés transversalement (MP1, MP2),
avec au moins un contact d'alimentation positif (VP) pour conduire un potentiel positif (VDD) d'une alimentation en tension,
avec au moins un contact d'alimentation négatif (VNi ; VN1, VN2, ..., VNn ; VNS3, VNS4 ; VNG4, VNG5) pour conduire un potentiel négatif (VSS) d'un dispositif d'alimentation en tension,
et avec une source de courant de repos (2) pour l'application, sur l'oscillateur, d'un courant de repos constant, sachant qu'un premier pôle de la source de courant de repos (2) est relié au contact d'alimentation positif (VP) et un second pôle de la source de courant de repos (2) est relié aux bornes Source (S1, S2) des transistors PMOS couplés transversalement (MP1, MP2),
**caractérisée en ce qu'**
il est prévu un bloc de diodes réglable (4), qui comporte une multitude de transistors NMOS (MNi ; MN1, MN2, ..., MNn), lesquels présentent respectivement une borne Source (SNi ; SN1, SN2, SNn), une borne Drain et une borne Gate,
sachant que leurs bornes Drain sont reliées avec la prise intermédiaire (CTAP) du circuit d'inductivité (L1, L2) et leurs bornes Source (SNi ; SN1, SN2, ..., SNn) sont reliées avec l'au moins un contact d'alimentation négatif (VNi ; VN1, VN2, .., VNn),
sachant qu'à chacun des transistors NMOS (MNi ; MN1, MN2, ..., MNn), il est respectivement attribué un circuit de commande (7), qui, en fonction d'un signal de programmation binaire (B1, B2, ..., BN), relie chaque borne Gâte soit à basse impédance avec la borne Drain respectif, soit avec la borne Source (SNi ; SN1, SN2, SNn) respectif.

2. Générateur d'horloge à bande large selon l'une des revendications précédentes, **caractérisé en ce que** les transistors NMOS (MNi ; MN1, MN2, ..., MNn) du bloc de diodes (4) comportent des canaux de transistor dont les rapports de format sont binairement hiérarchisés.

3. Générateur d'horloge à bande large selon l'une des revendications précédentes, **caractérisé en ce que** les transistors NMOS (MNi ; MN1, MN2, ..., MNn) du bloc de diodes (4) comportent des canaux de transistor dont les rapports de format sont thermométriquement hiérarchisés.

4. Générateur d'horloge à bande large selon l'une des revendications précédentes, **caractérisé en ce que** les transistors NMOS (MNi ; MN1, MN2, ..., MNn) du bloc de diodes (4) sont respectivement formés dans une cuvette N profonde.

5. Générateur d'horloge à bande large selon l'une des revendications précédentes, **caractérisé en ce que** les circuits de commande (7) pour les transistors NMOS (MN1, MN2, ..., MNn) comportent respectivement deux commutateurs pilotés de manière complémentaire, dont un est disposé entre la borne Drain et la borne Gâte et l'autre entre la borne Source et la borne Gâte du transistor NMOS respectif.

6. Générateur d'horloge à bande large selon la revendication précédente, **caractérisé en ce que** les commutateurs sont deux transistors de commutation NMOS utilisés de préférence en saturation, sachant qu'un inverseur (8) est disposé entre les bornes Gâte des transistors de commutation NMOS de l'un des circuits de commande (7).

7. Générateur d'horloge à bande large selon la revendication précédente, **caractérisé en ce que** le signal de programmation binaire (B1, 82, ..., BN) attribué au circuit de commande respectif (7) est transmis à l'une des bornes Gate des transistors de commutation NMOS respectifs.

8. Générateur d'horloge à bande large selon l'une des revendications précédentes, **caractérisé en ce que**, pour le traitement du signal d'oscillateur différentiel, il est prévu un circuit de traitement différentiel (5) qui comporte deux contacts d'entrée (Clk, Clkb), lesquels sont reliés avec une borne Gate d'au moins un transistor NMOS d'entrée (M3, M4) du circuit de traitement (5), sachant que les bornes de sortie (CK, CKb) de l'oscillateur (1) et les contacts d'entrée (Clk, Clkb) du circuit de traitement (5) sont couplés en tension continue.

9. Générateur d'horloge à bande large selon la revendication précédente, **caractérisé en ce que** le circuit de traitement (5) est un diviseur de fréquence (5).

10. Générateur d'horloge à bande large selon la revendication précédente, **caractérisé en ce que** le diviseur de fréquence (5) est un diviseur de fréquence par deux (5), qui comporte deux portes D-Latch différentielles (6), lesquelles sont disposées en une configuration maître-esclave avec rétroaction négative, sachant que le signal d'oscillateur différent est transmis à chacune des portes D-Latch (6), sachant que chaque porte D-Latch (6) présente deux transistors NMOS d'entrée de porte (M3, M4), qui forment respectivement l'un desdits transistors MOS d'entrée (M3, M4) du circuit de traitement (5).

11. Générateur d'horloge à bande large selon la revendication précédente, **caractérisé en ce que** les bornes Source (S3, S4) des transistors NMOS d'entrée de porte (M3, M4) sont reliés avec l'un des contacts d'alimentation négatifs (VNS3, VNS4).

12. Générateur d'horloge à bande large selon l'une des revendications 10 ou 11, **caractérisé en ce que** les portes D-Latch (6) présentent respectivement deux sorties (Q, Qb), qui sont respectivement reliées avec l'un des contacts d'alimentation positifs via une résistance (R1, R2).

13. Générateur d'horloge à bande large selon l'une des revendications 10 ou 11, **caractérisé en ce que** les portes D-Latch (6) présentent respectivement deux sorties (Q, Qb), qui sont respectivement reliées avec une borne Drain d'un transistor PMOS (MP4, MP5), qui présente une borne Gate reliée avec l'un des contacts d'alimentation négatifs (VNG4, VNG5) et une borne Source reliée avec l'un des contacts d'alimentation positifs.

14. Générateur d'horloge à bande large selon l'une des revendications précédentes, **caractérisé en ce que** la source de courant de repos (2) comporte un transistor PMOS (MP3), qui présente une borne Source, une borne Drain et une borne Gate (G3), sachant que la borne Source est relié avec le premier pôle de la source de courant de repos (2), sachant que la borne Drain est reliée avec le second pôle de la source de courant de repos (2), et sachant que la borne Gâte (G3) est reliée avec une sortie (Vbias) d'un circuit d'alimentation pour le réglage du courant de repos de l'oscillateur (1).

15. Générateur d'horloge à bande large selon l'une des revendications précédentes, **caractérisé en ce que** le circuit d'inductivité (L1, L2) présente des éléments d'inductivité (L1, L2) formés dans au moins une couche métallique, qui se présentent respectivement de préférence sous la forme de bobines spiralées (L1, L2).
